Europäisches Patentamt

European Patent Office

Office européen des brevets

(11) Publication number: 0 200 552
A1

## (12) EUROPEAN PATENT APPLICATION

(21) Application number: 86303321.3

(22) Date of filing: 01.05.86

(51) Int. Cl.⁴: **H 01 L 27/14**
**H 01 L 21/76**

(30) Priority: 01.05.85 JP 92289/85

(43) Date of publication of application:
05.11.86 Bulletin 86/45

(84) Designated Contracting States:
DE FR GB NL

(71) Applicant: CANON KABUSHIKI KAISHA
30-2, 3-chome, Shimomaruko
Ohta-ku Tokyo(JP)

(72) Inventor: Arikawa, Shiro
687-17 Nishitomi
Fujisawa-shi Kanagawa-ken(JP)

(72) Inventor: Sugawa, Shigetoshi
28-4-301 Morinosato 1-chome
Atsugi-shi Kanagawa-ken(JP)

(74) Representative: Beresford, Keith Denis Lewis et al,
BERESFORD & Co. 2-5 Warwick Court High Holborn
London WC1R 5DJ(GB)

(54) Photoelectric converting device.

(57) A photoelectric converting device comprises a plurality of photoelectric converting cells. Each cells has a semiconductor transistor consisting of two main electrode regions (12) (4) formed of a semiconductor of one conductivity type and a control electrode region (10) formed of a semiconductor of the opposite conductivity type, and a capacitor (11) (13) (10) for controlling a potential of the control electrode region in a floating state.

Each of the photoelectric converting cells performs at least the operations to accumulate carriers generated due to an incident light into the control electrode region and read out an accumulated voltage generated due to the accumulated carriers by controlling the potential of the control electrode region in the floating state through the capacitor.

An insolating region for electrically isolating the adjacent photoelectric converting cells is constituted by an insulating region (8) formed on the basis of a concave portion formed due to an etching and a semiconductor region (7) having a high concentration formed under the insulating region.

The high concentration semiconductor region consists of a semiconductor of the same conductivity type as that of the main electrode regions of the photoelectric converting cells.

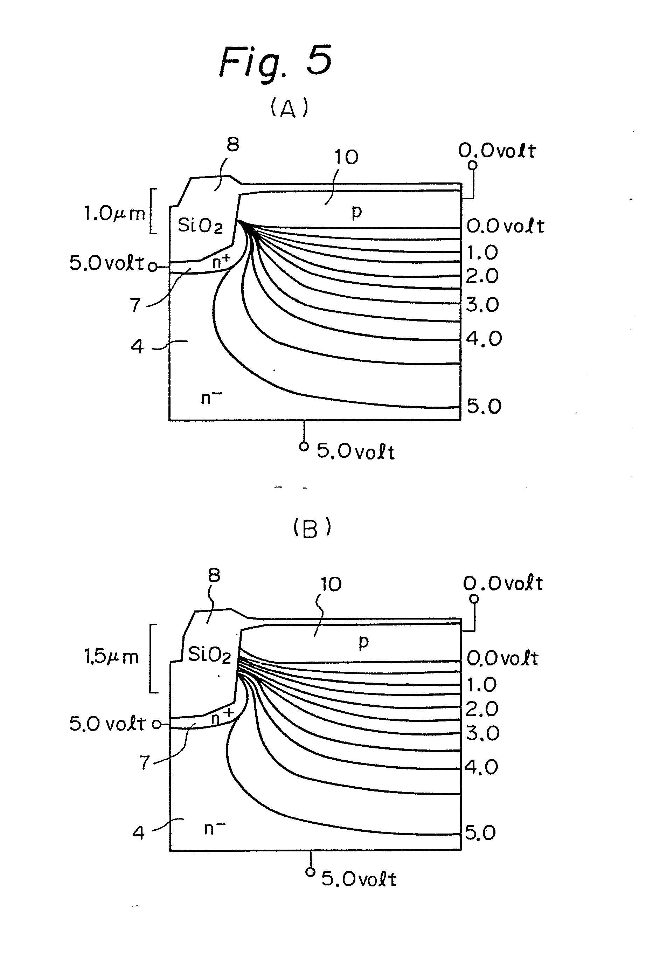

' *Fig. 4*

# TITLE OF THE INVENTION

## PHOTOELECTRIC CONVERTING DEVICE

## BACKGROUND OF THE INVENTION

### Field of the Invention

The present invention relates to a photoelectric converting device having a photocharge accumulating region whose potential is controlled through a capacitor.

### Description of the Prior Art

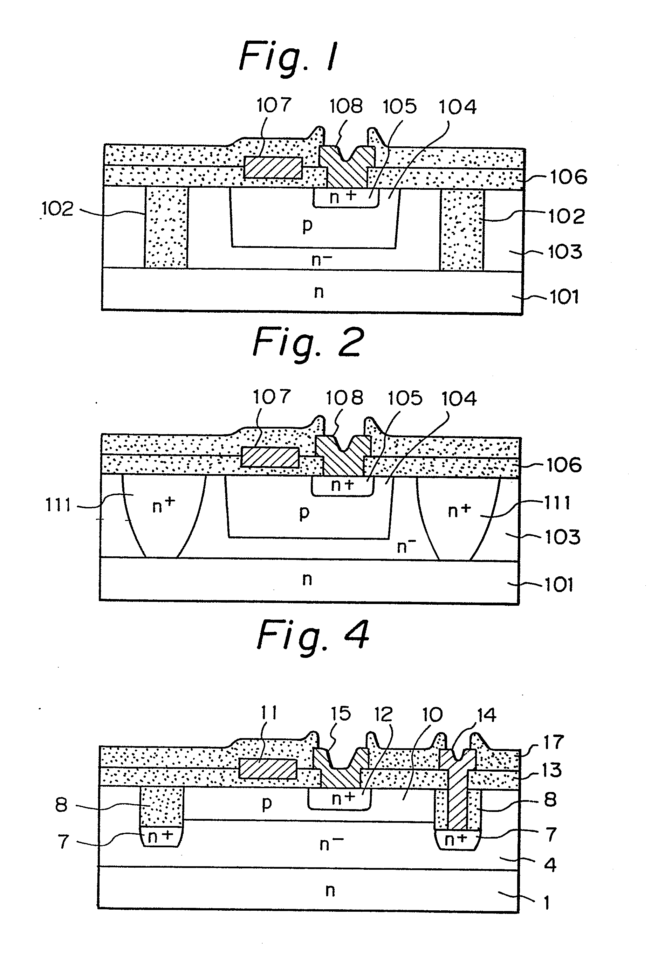

Fig. 1 is a schematic cross sectional view of the photoelectric converting device disclosed in the Official Gazette of EPC Application Laid-Open No. 0132076.

In the diagram, photo sensor cells are formed and arranged on an n-type silicon substrate 101. Each photo sensor cell is electrically insulated from the adjacent photo sensor cells by an element isolating region 102 consisting of $SiO_2$ or the like.

Each of the photo sensor cells has the following constitution.

An $n^-$ region 103 having a low impurity concentration is formed by an epitaxial technique or the like. A p region 104 is formed on the $n^-$ region 103 by doping p-type impurities. An $n^+$ region 105 is formed in a p region 104 by impurity diffusion technique or ion implantation technique or the like.

The p region 104 and $n^+$ region 105 serve as a base and an emitter of a bipolar transistor, respectively.

An oxide film 106 is formed on the $n^-$ region 103 formed with those respective regions in this way. A capacitor electrode 107 having a predetermined area is formed on the oxide film 106. The capacitor electrode 107 faces the p region 104 so as to sandwich the oxide film 106. A potential of the p region 104 in the floating state is controlled by applying a pulse voltage to the capacitor electrode 107.

In addition, an emitter electrode 108 connected to the $n^+$ region 105 is formed, and an electrode to apply a potential to a collector of the bipolar transistor through an $n^+$ region having a high impurity concentration and the like are formed on the back surface of the substrate 101, respectively.

The fundamental operation of the photoelectric converting device shown in Fig. 1 will then be described. A light enters the p region 104 as the base of the bipolar transistor and the charges corresponding to an amount of incident light are accumulated into the p region 104 (accumulating operation). A base potential changes due to the accumulated charges and by reading out the potential change from the emitter electrode 108 in the floating state, an electrical signal corresponding to the incident light amount can be obtained (reading operation). On one hand, to remove the charges accumulated in the p region 104, the emitter electrode 108 is grounded and a pulse of a positive voltage is applied to the capacitor electrode 107 (refreshing operation). By applying the positive voltage, the p region 104 is forwardly biased with respect to the $n^+$ region 105 and the accumulated charges are removed. Thereafter, the accumulating, reading, and refreshing operations are repeated.

In other words, according to the system proposed in the conventional device, the charges generated due to the incident light are accumulated into the p region 104 as the base and a current flowing between the emitter and collector is controlled by the amount of accumulated charges. Therefore, after the accumulated charges were amplified by the amplifying function of each cell, they are read out, so that high power, high sensitivity, and further low noise can be accomplished.

In the above photoelectric converting device, the element isolating region 102 consisting of an insulating material is provided to prevent the extent in the lateral direction of the depletion layer of each photo sensor cell. As a method of forming such an element isolating region 102, there are the method whereby the $n^-$ layer 103 is etched until a predetermined depth to form a concave portion and this concave portion is filled with an insulating material and the method whereby a selective epitaxial growth (SEG) method is used.

However, according to the former method whereby the concave portion is formed, a damage or a defect occurs in the $n^-$ layer 103 due to the etching process. Further, the residual is formed in the groove portion due to the reaction of the etching gas and the photo resist. The electrical characteristic of the element deteriorates due to this pollution or the like, in particular, a leak current and a dark current between the elements increase.

According to the method whereby the SEG method is used, an oxide is preliminarily formed due to the thermal oxidation, CVD method, or the like and only the portion of the element isolating region 102 is left due to the etching process. Subsequently, polysilicon, silicon nitride, or the like is formed in the side wall portion by an LPCVD method or the like. The $n^-$ layer 103 is deposited between the element isolating regions due to the epitaxial growth method.

However, there are the problems such that the crystalline property of the portion near the boundary between the $n^-$ layer 103 as the element region and the element isolating region 102 deteriorates

0200552

and the leak current increases due to the shape of the element isolating region which is formed by the etching and due to the influence of the thin film formed in the side wall portion.

Fig. 2 is a schematic cross sectional view of a photoelectric converting device formed with the element isolating region due to the diffusion of impurities.

To form an $n^+$ element isolating region 111 as shown in Fig. 2, it is sufficient to diffuse the impurities until a predetermined depth, so that the manufacturing becomes easy. However, this method has the problem such that the diffusion of the impurities also progresses in the lateral direction and a width of the element isolating region 111 becomes 1.5 to 2 times or more larger than the depth of diffusion, so that a limitation occurs in the case of fining the elements.

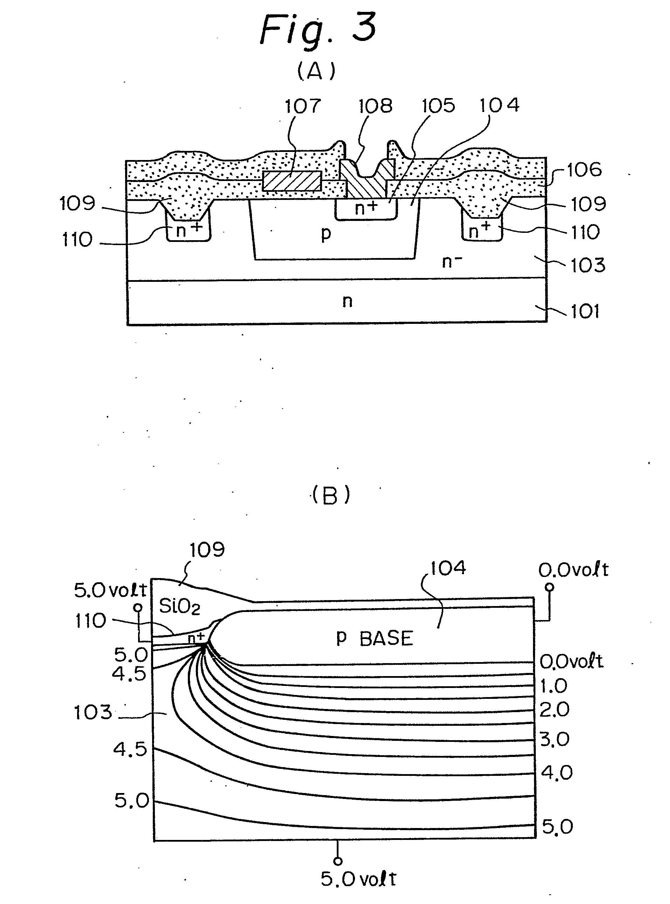

Fig. 3(A) is a schematic cross sectional view of a photoelectric converting device formed with an element isolating region by use of a selective oxidation method. Fig. 3(B) is a potential distribution diagram of the device of Fig. 3(A).

In this example, the element isolating region is constituted by an oxide film 109 selectively grown by an LOCOS method and an $n^+$ region 110 formed just under the oxide film 109.

However, the selective oxidation method has the problem such that it is difficult to oxidize until a depth over 1 $\mu$m from the surface of the silicon layer, so that the electrical isolation is insufficient. As shown in Fig. 3.(B), the equipotential line of 5.0 volts is cut on the sides of the $n^+$ region 110 and $n^-$ layer 103 and the depletion layers of the adjacent elements are connected, so that a part of the carriers generated due to the incident light are accumulated into the base regions of the other elements, causing the resolution to deteriorate.

Further, the selective oxidation method has the problem called a bird's beak regarding the extent in the lateral direction of the oxide film, which is peculiar to this method, so that it has also the problem such that a width of the element isolating region is widened, resulting in that it is difficult to realize high integration.

SUMMARY OF THE INVENTION

It is an object of the present invention to provide a photoelectric converting device which can solve the foregoing conventional problems for higher integration.

Another object of the invention is to provide a photoelectric converting device comprising a plurality of photoelectric converting cells which are arranged and each of which has: a semiconductor transistor consisting of two main electrode regions formed of a semiconductor of one conductivity type and a control electrode region consisting of a semiconductor of the opposite conductivity type; and a capacitor for controlling a potential of the control electrode region in the floating state, wherein each of the photoelectric converting cells executes at least the operations to accumulate carriers generated due to an incident light into the control electrode region and read out an accumulated voltage generated due to the accumulated carriers by controlling the potential of the control electrode region in the floating state through the capacitor, and an isolating region to electrically isolate the adjacent photoelectric converting cells is composed of an insulating region formed on the basis of a concave portion formed due to an etching and a semiconductor region having a high concentration formed under the insulating region, and the high concentration semiconductor region consists of a semiconductor of the same conductivity type as that of the main electrode region of the photoelectric converting cell.

BRIEF DESCRIPTION OF THE DRAWINGS

Fig. 1 is a schematic cross sectional view of a photoelectric converting device disclosed in the Official Gazette of EPC Application Laid-Open No. 0132076.

Fig. 2 is a schematic cross sectional view of a conventional photoelectric converting device formed with an element isolating region due to a diffusion of impurities;

Fig. 3(A) is a schematic cross sectional view of a conventional photoelectric converting device formed with an element isolating region by use of a selective oxidation method;

Fig. 3(B) is a potential distribution diagram of the device of Fig. 3(A);

Fig. 4 is a cross sectional view of one cell in one embodiment of a photoelectric converting device according to the present invention;

Figs. 5(A) and 5(B) are potential distribution diagrams of the device of the embodiment;

Figs. 6(A) to 6(K) are diagrams for explaining the manufacturing process of the embodiment;

Figs. 7(A) to 7(D) are diagrams for explaining the second manufacturing process of the embodiment;

Figs. 8(A) and 8(B) are diagrams for explaining the third manufacturing process of the embodiment; and

Figs. 9.(A) to 9(C) are diagrams for explaining the fourth manufacturing process of the embodiment.

DETAILED DESCRIPTION OF PREFERRED EMBODIMENTS

An embodiment of the present invention will now be described in detail hereinbelow with reference to the drawings.

Fig. 4 is a cross sectional view of one cell in the first embodiment of a photoelectric converting device according to the embodiment.

A constitution of the embodiment is substantially the same as that of the conventional example shown in Figs. 1 to 3 except the element isolating region. Namely, an $n^-$ epitaxial layer 4 is formed on an n-type silicon substrate 1. A p base region 10, an $n^+$ emitter region 12, a capacitor electrode 11, and the like are formed in the $n^-$ epitaxial layer 4. Although not shown, a collector electrode is formed on the back surface of the substrate 1.

An element isolating region is constituted by an insulating region 8 and an $n^+$ region 7 formed just under the insulating region 8. In this embodiment, the insulating region 8 is formed by burying an oxide into a concave portion formed due to an etching as will be explained later. A proper voltage is applied to the $n^+$ region 7 by an element isolating control electrode 14.

Figs. 5(A) and 5(B) are potential distribution diagrams of the embodiment. Fig. 5(A) shows the case where a depth of concave portion which is formed due to the etching is about 1 μm. Fig. 5(B) shows the case where the depth is about 1.5 μm. A voltage of 5 volts is applied to the $n^-$ layer 4 and $n^+$ region 7. The p base region 10 is grounded.

Even when the depth of etching is about 1 μm as well as mentioned above, the potentials of the element isolating region and the portion lower thereof are held at 5V. It will be understood that the isolating effect which is substantially equivalent to the cases of the deep element isolating regions as shown in Figs. 1 and 2 is obtained. Further, in the case where the depth of etching is about 1.5 μm, the junction capacitance between the p base region 10 and the $n^-$ layer 4 serving as a collector region can be also reduced. The effect of preventing a decrease in output is also derived.

The manufacturing process of the embodiment will then be described.

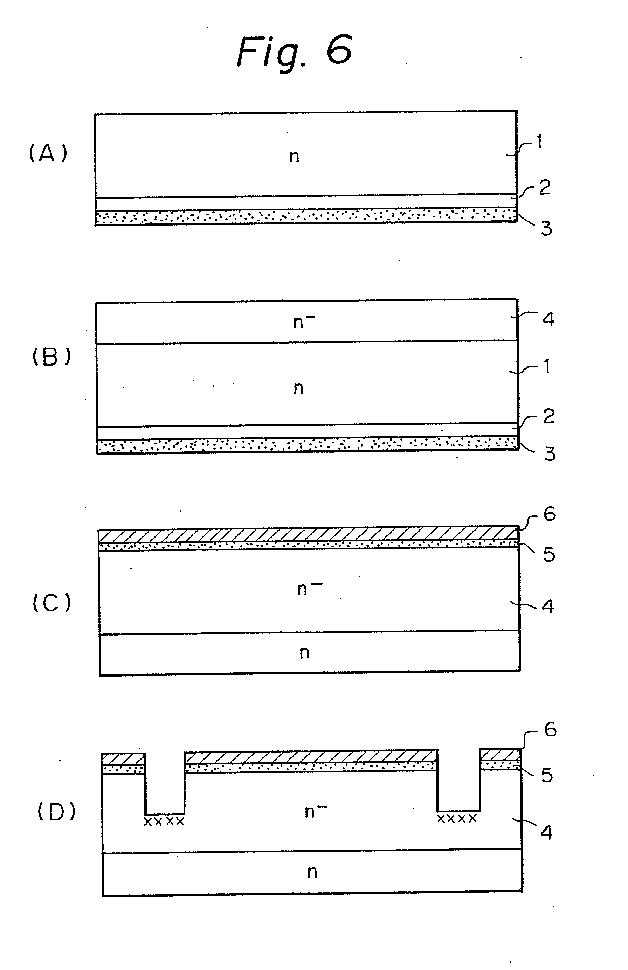

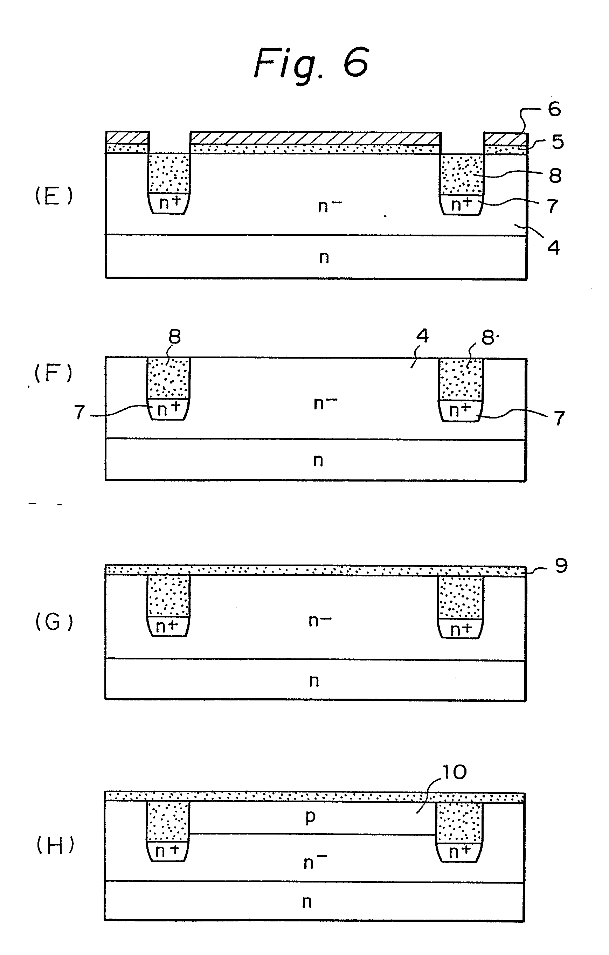

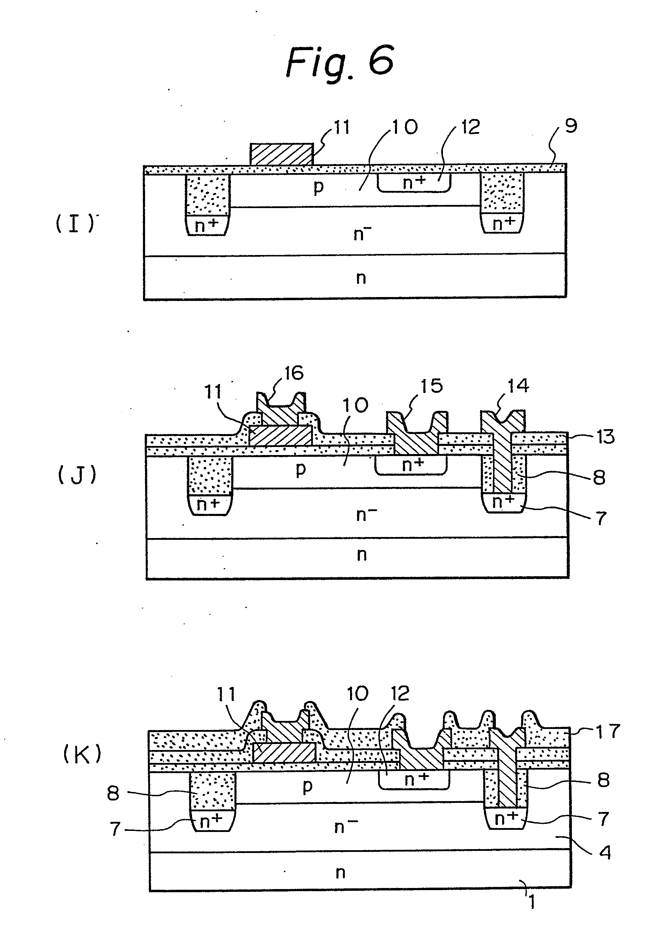

Figs. 6(A) to 6(K) are diagrams for explaining the manufacturing process of the embodiment.

First, as shown in Fig. 6(A), an $n^+$ layer 2 for ohmic contact having an impurity concentration of $1 \times 10^{17}$ to $1 \times 10^{20}$ cm$^{-3}$ is formed on the back surface of the n-type silicon substrate 1 having an impurity concentration of $1 \times 10^{15}$ to $1 \times 10^{17}$ cm$^{-3}$ due to a diffusion of P, As, or Sb. Then, an oxide film 3 (e.g., SiO$_2$ film) having a thickness of 3000

to 7000 $\overset{\circ}{A}$ is formed on the $n^+$ layer 2 due to a CVD method.

The oxide film 3 is called a back coat and serves to prevent the generation of the impurity vapors when the substrate 1 is subjected to a heat treatment.

Next, the surface of the substrate 1 is etched for about one and half minutes at a temperature of 1000°C under the condition of HC$\ell$ of 2 $\ell$/min and $H_2$ of 60 $\ell$/min. Thereafter, for example, a source gas $SiH_2Cl_2$ (100%) of 1.2 $\ell$/min and a doping gas ($PH_3$ diluted by $H_2$, 20 ppm) of 100 m$\ell$ are poured. The $n^-$ epitaxial layer 4 (hereinafter, referred to as an $n^-$ layer 4) is formed at a growth temperature of 1000°C and at a reduced pressure of 120 to 180 Torr. In this case, the growth speed of monocrystal is 0.5 μm/min, the thickness is 2 to 10 μm, and the impurity concentration is $1 \times 10^{12}$ to $10^{16}$ $cm^{-3}$, preferably, $10^{12}$ to $10^{14}$ $cm^{-3}$ (Fig. 6(B)).

To improve the quality of the $n^-$ layer 4, the substrate is first subjected to a heat treatment at high temperatures of 1150 to 1250 °C to remove oxygen from the portion near the surface. Then, a number of microdefects are generated in the substrate due to a heat treatment at a temperature of about 800°C for a long period of time, thereby obtaining the substrate having the denuded zone in which the intrinsic gettering can be carried out. This method is extremely effective to improve the quality of the n$^-$ layer 4.

Subsequently, an oxide film 5 for pad having a thickness of 500 to 1500 Å is formed on the n$^-$ layer 4 due to the pyrogeneic oxidation ($H_2$ + $O_2$), wet oxidation ($O_2$ + $H_2O$), steam oxidation ($N_2$ + $H_2O$), or dry oxidation. Further, to obtain a good oxide film having no stacking fault or the like, it is suitable to perform the oxidation at temperatures of 800 to 1000 °C and at a high pressure. Further, a silicon nitride film ($Si_3N_4$) 6 having a thickness of 500 to 2000 Å is deposited by an LPCVD method or P-CVD method (Fig. 6(C)).

The LPCVD method was used in this example. The good nitride film 6 was obtained under the conditions of the deposition temperatures of 750 to 850 °C, the deposition pressure of 0.2 to 0.4 Torr, $SiH_2Cl_2$ of 20 to 50 SCCM, and $NH_3$ of 70 to 150 SCCM.

Next, the nitride film 6 and oxide film 5 of the portions where the element isolating region is formed are removed due to a dry etching method such as plasma etching method, reactive ion etching method, or the like. Subsequently, the n$^-$ layer 4 is etched and removed until a depth of 0.5 to 1.5 μm due to a reactive ion etching using the nitride film 6 as a mask, thereby forming a concave portion. In this case, it is desirable to suppress the etching in the lateral direction by providing an anisotropy by selecting an etching gas. Then, As ions as n-type impurities are implated into the bottom portion of the concave portion by way of an ion implantation method by use of the nitride film 6 as a mask similarly (Fig. 6(D)).

In this example, the good result was obtained by performing the etching under the conditions of the etching gas of $C\ell_2 + N_2$, the vacuum degree of 2 to 3 Pa, and the RF power of 0.2 to 0.4 $W/cm^2$.

Next, the As ions implanted in the $N_2$ gas are activated and the concave portion is filled with silicon oxide under an atmosphere of $(N_2 + H_2O)$ or $(H_2 + O_2)$, thereby forming the insulating region 8 and $n^+$ region 7 (Fig. 6(E)).

The nitride film 6 and pad oxide film 5 are then removed (Fig. 6(F)).

The surface of the $n^-$ layer 4 is oxidized to form the oxide film 9 (Fig. 6(G)).

Next, ions of p-type impurities are implanted due to an ion implantation method and the p base region 10 of a predetermined depth is formed due to a heat treatment (Fig. 6(H)).

Polysilicon is then deposited onto the oxide film 9 due to a CVD method or the like. The polysilicon electrode 11 serving as a capacitor electrode is formed due to a patterning. Subsequently, the $n^+$ emitter region 12 is formed due to an ion implantation method or the like (Fig. 6(I)).

In this example, good polysilicon could be deposited under the conditions of the deposition temperatures of 600 to 640 °C, the deposition pressure of 0.2 to 0.4 Torr, and $SiH_4$ of a flow rate of 20 to 100 SCCM.

After an insulating film 13 between layers was formed by a CVD method or the like, contact holes are formed on the $n^+$ region 7, emitter region 12, and polysilicon electrode 11, respectively. Aℓ is evaporated and deposited in the contact holes and the element isolating control electrode 14, an emitter electrode 15, and an electrode 16 connected to the polysilicon electrode 11 are formed by a patterning, respectively, (Fig. 6(J)).

Subsequently, a surface protecting film 17 such as $SiO_2$ doped with P, $Si_3N_4$, or the like is formed due to a CVD method or P-CVD method or the like and the photoelectroc converting device is formed in this manner (Fig. 6(K)).

The step of Fig. 6(D) and subsequent steps can be also changed as will be explained hereinafter.

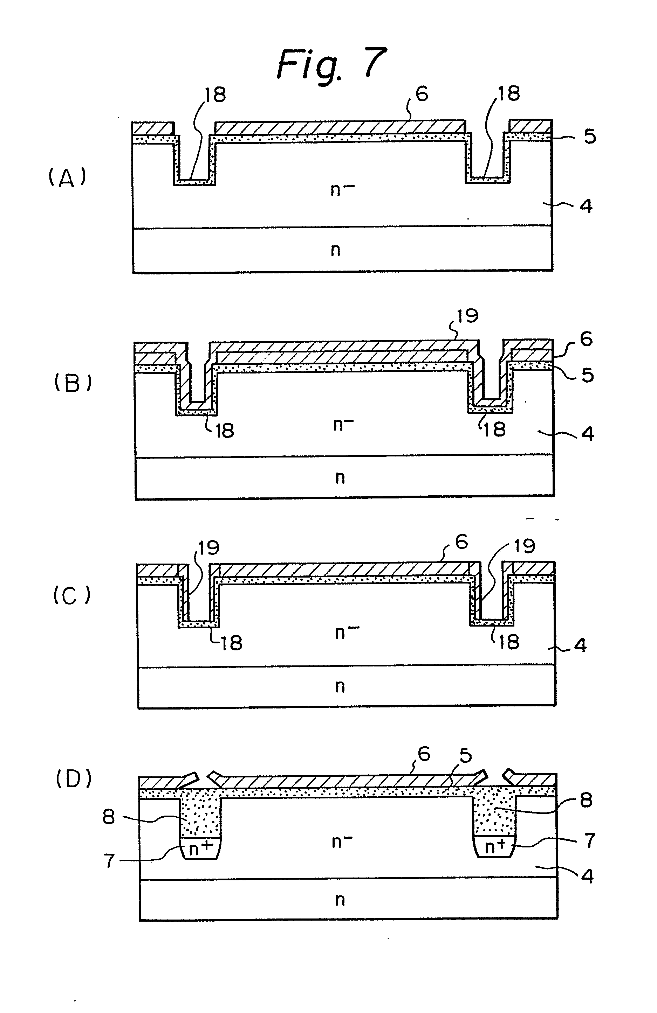

Figs. 7(A) to 7(D) are diagrams for explaining the second manufacturing process of the embodiment.

First, after completion of the step of Fig. 6(D), the oxidation is performed to form an oxide film 18 having a thickness of 500 to 2000 Å in the concave portion (Fig. 7(A)).

Then, a silicon nitride film 19 having a thickness of 500 to 2000 Å is formed by an LPCVD method or the like (Fig. 7(B)).

The silicon nitride film 19 in the bottom portion of the concave portion is removed due to a reactive ion etching, thereby allowing the nitride film 19 on the side wall surface of the concave portion to be left (Fig. 7(C)).

Subsequently, the concave portion is filled with silicon oxide due to a selective oxidation and the insulating region 8 is formed and at the same time, the $n^+$ region 7 is formed by diffusing the impurities of As which have already been ion-implanted (Fig. 7(D)).

Next, the nitride film 6 and oxide film 5 are removed and thereafter the photoelectric converting device is manufactured by the steps similar to those shown in Figs. 6(F) to 6(K).

According to the second manufacturing method, the nitride film 19 is left on the side wall surface of the concave portion and the selective oxidation is carried out, so that a lateral extent of the isolating region can be suppressed and the finer element isolating region can be formed.

The step of Fig. 6(D) and subsequent steps are not limited to the steps by way of a growth of the oxide film from the $n^-$ layer 4 but a dielectric material or polysilicon may be also buried as will be explained hereinbelow.

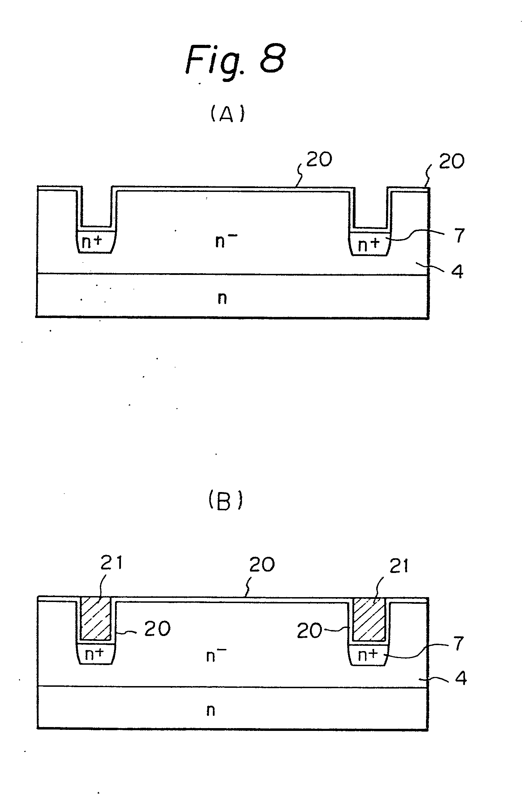

Figs. 8(A) and 8(B) are diagrams for explaining the third manufacturing process of the embodiment.

After completion of the step shown in Fig. 6(D), the nitride film 6 and oxide film 5 are removed. Then the oxidation is performed to form an oxide film 20 having a thickness of 200 to 2000 $\overset{o}{A}$ and the implanted As ions are diffused to form the $n^+$ region 7 (Fig. 8(A)).

Next, polysilicon (or dielectric material) 21 is filled in the concave portion surrounded by the oxide film 20 due to an LPCVD method, CVD method, spin-on glass method, bias sputtering method, or the like.

In the case of forming the polysilicon layer 21 due to an LPCVD method, the conditions are such that, for instance, the temperature is 580 to 650 °C, the vacuum degree is 20 to 100 Pa, and the flow rate of Si is 20 to 100 SCCM. In the case of forming the silicon nitride film by the same method, the conditions are such that, for example, the temperature is 750 to 850 °C, the vacuum degree is 20 to 100 Pa, the flow rate of $SiH_2Cl_2$ is 20 to 100 SCCM, and the flow rate of $NH_3$ is 50 to 500 SCCM.

In the case of using a CVD method, the concave portion can be filled with the silicon oxide film under the conditions of, e.g., the growth temperatures of 350 to 450 °C, 4% $SiH_4$ of a flow rate of 500 to 2000 SCCM, and $O_2$ of a flow rate of 500 to 1500 SCCM.

In the case of using a spin-on glass method, the concave portion can be filled with a dielectric material such as a silicon oxide film or the like by use of, for example, a silica film source of an $SiO_2$ concentration of 3 to 6 % under the condition of a rotating speed of 1000 to 3000 rpm.

According to a bias sputtering method, on one hand, the concave portion can be filled with a silicon oxide film under the conditions of, e.g., a substrate bias voltage of -50 to -200 V, an accelerating voltage of 800 to 1400 V, and a vacuum degree of $3 \sim 7 \times 10^{-1}$ Pa.

The concave portion is filled with the dielectric material or polysilicon 21 by the above method and the dielectric material or polysilicon of the portions other than the concave portion is then removed due to an etch-back method (Fig. 8(B)). In this example, the oxide film 20 and the region surrounded by the oxide film 20 become the insulating region 8. In the case of burying polysilicon 21 into the portion inside of the concave portion, polysilicon 21 can be used as an electrode or wiring to apply a potential to the $n^+$ region 7. Thereafter, the photoelectric converting device is manufactured by the steps similar to those shown in Figs. 6(F) to 6(K).

In addition to an etch-back method, the dielectric material 21 can be also flattened by a lift-off method which will be explained hereinbelow.

The step of Fig. 6(D) and subsequent steps may be also carried out by the following lift-off method.

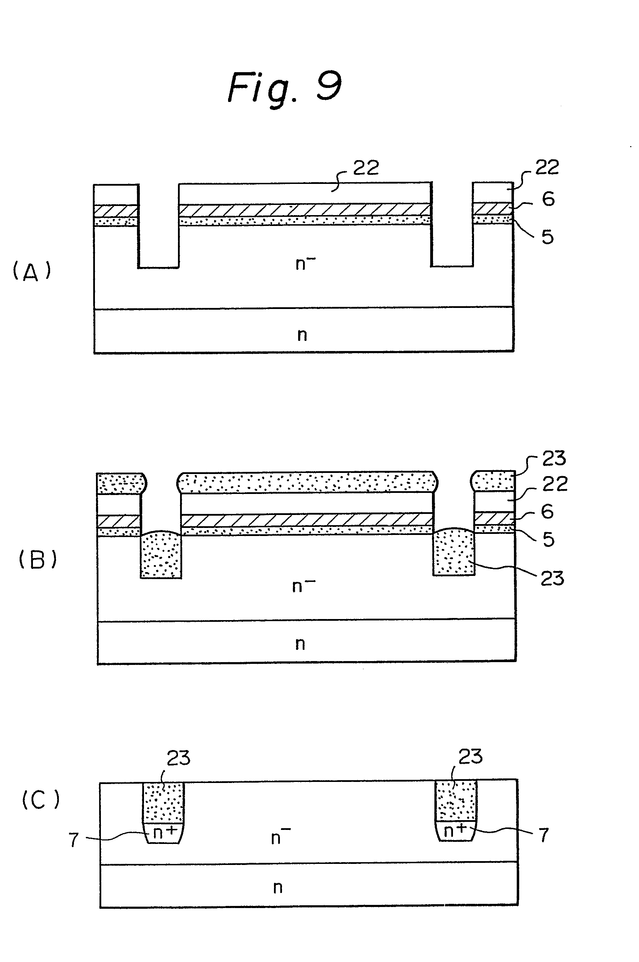

Figs. 9(A) to 9(C) are diagrams for explaining the fourth manufacturing process of the embodiment.

In the step of Fig. 6(D), the concave portion is formed due to an etching and As ions are implanted and thereafter a photo resist 22 is left without being removed (Fig. 9(A)).

Next, a dielectric material 23 (e.g., silicon oxide film or silicon nitride film) is deposited onto the concave portion and resist 22 due to an ECR plasma CVD method, a spin-on glass method, or the like (Fig. 9(B)).

In the case of forming the silicon oxide film by an ECR plasma method, the conditions are such that, for example, the RF power is 500 W, the flow rate of $SiH_4$ is 5 to 50 SCCM, the flow rate of $N_2$ is 5 to 50 SCCM, the vacuum degree of $3 \times 10^{-2}$ to $1 \times 10^{-1}$ Pa, and the deposition speed is 50 to 600 Å/min.

As mentioned above, the silicon oxide film may be also formed by a spin-on glass method.

Next, only the dielectric material 23 in the concave portion is left by removing the resist 22 and subsequently ion-implanted As is thermally diffused in the $N_2$ gas, thereby forming the $n^+$ region 7. Therefore, in this example, the dielectric material 23 forms the insulating region 8. Then, the nitride film 6 and oxide film 5 are removed (Fig. 9(C)).

Thereafter, the photoelectric converting device is formed by the steps similar to those shown in Figs. 6(F) to 6(K).

Although the $n^+$ semiconductor was used for the semiconductor region just under the insulating region 8 in this embodiment, the invention is not obviously limited to this. In the case of a PNP bipolar transistor, a $p^+$ semiconductor may be used.

As described in detail above, in the photoelectric converting device according to this embodiment, since the semiconductor region having a high concentration is formed under the insulating region, an amount of etching is small and a width of isolating region is narrow and also the deep isolation can be attained.

Since the amount of etching is small, a damage which is exerted to the semiconductor can be reduced and the occurrence of the crystal fault and a leak current between elements can be suppressed. Consequently, the crosstalk between cells can be minimized and a high resolution can be realized.

In addition, a lateral width of isolating region can be reduced and sufficient isolation between elements can be accomplished, so that the invention is suitable for realization of higher integration and higher resolution as compared with the conventional device.

CLAIMS:

1.  A photoelectric converting device comprising a plurality of photoelectric converting cells which are arranged and each of which has:

a semiconductor transistor consisting of two main electrode regions formed of a semiconductor of one conductivity type and a control electrode region formed of a semiconductor of the opposite conductivity type; and

a capacitor for controlling a potential of said control electrode region in a floating state.

wherein each of said photoelectric converting cells performs at least the operations to accumulate carriers generated due to an incident light into said control electrode region and read out an accumulated voltage generated due to said accumulated carriers by controlling the potential of said control electrode region in the floating state through said capacitor,

an isolating region for electrically isolating said adjacent photoelectric converting cells is constituted by an insulating region formed on the basis of a concave portion formed due to an etching and a semiconductor region having a high concentration formed under said insulating region, and

said high concentration semiconductor region consists of a semiconductor of the same conductivity type as that of the main electrode regions of said photoelectric converting cells.

2. A photoelectric converting device according to claim 1, wherein said insulating region consists of an insulating material filled in said concave portion.

3. A photoelectric converting device according to claim 1, wherein said insulating region consists of an insulating film formed along said concave portion and a conductive material surrounded by said insulating film.

## Fig. 1

## Fig. 2

## Fig. 4

# Fig. 3

## (A)

## (B)

# Fig. 5

(A)

(B)

# Fig. 6

(A)

(B)

(C)

(D)

# Fig. 6

(E)

6
5
8
7
4

n⁺   n⁻   n⁺

n

(F)

8          4          8·

7   n⁺        n⁻        n⁺   7

n

(G)

9

n⁺        n⁻        n⁺

n

(H)

10

p
n⁺        n⁻        n⁺

n

# Fig. 6

(I)

(J)

(K)

# Fig. 7

(A)

(B)

(C)

(D)

## Fig. 8

(A)

(B)

## Fig. 9

(A)

22
6
5

n⁻

n

(B)

23
22
6
5
23

n⁻

n

(C)

23    23

7   n+   n⁻   n+   7

n

## DOCUMENTS CONSIDERED TO BE RELEVANT

| Category | Citation of document with indication, where appropriate, of relevant passages | Relevant to claim | CLASSIFICATION OF THE APPLICATION (Int. Cl 4) |
|---|---|---|---|
| Y,D | EP-A-0 132 076 (O. TADAHIRO)<br>* Figure 1; claim 1 * | 1,2 | H 01 L 27/14<br>H 01 L 21/76 |
| Y | DE-A-3 326 924 (OLYMPUS OPTICAL CO.)<br>* Figure 6; page 14, lines 29-41 * | 1,2 | |
| A | IBM TECHNICAL DISCLOSURE BULLETIN, vol. 26, no. 7A, December 1983, pages 3188-3189, New York US; S.D. MALAVIYA: "Deep dielectric isolation"<br>* Figure 5 * | 1,2 | |
| A | INTERNATIONAL ELECTRON DEVICES MEETING, TECHNICAL DIGEST, December 13-15,1982, San Francisco, CA; pages 62-65; IEEE, New York, US; A.HAYASAKA et al.: " U-Groove isolation technique for high speed bipolar VLSI's".<br>* Page 63,: figure 2A * | 3 | **TECHNICAL FIELDS SEARCHED (Int. Cl 4)**<br><br>H 01 L |

The present search report has been drawn up for all claims

| Place of search | Date of completion of the search | Examiner |
|---|---|---|
| THE HAGUE | 18-07-1986 | CARDON A. |